# EUROPEAN PATENT SPECIFICATION

(11) **EP 2 245 486 B1**
(45) Date of publication and mention of the grant of the patent: **15.01.2014**
(21) Application number: 08872398.6
(22) Date of filing: 15.12.2008
(51) Int. Cl.: B29D 11/00, G02B 1/10, G02B 1/11

(54) **POLYMERIC BASED LENS COMPRISING A HARDENING LAYER, AN INTERFERENTIAL MULTI- LAYER AND A HARD LAYER SANDWICHED BETWEEN BOTH, AND CORRESPONDING MANUFACTURING METHOD**
AUF POLYMER BASIERENDE LINSE MIT EINER HÄRTUNGSSCHICHT, EINER INTERFERENZ-MEHRSCHICHT UND EINER ZWISCHEN BEIDEN GESCHICHTETEN HARTEN SCHICHT UND ENTSPRECHENDES HERSTELLUNGSVERFAHREN
LENTILLE POLYMÈRE COMPRENANT UNE COUCHE DE DURCISSEMENT, UNE MULTICOUCHE INTERFÉRENTIELLE ET UNE COUCHE DURE INTERCALÉE ENTRE LES DEUX, ET PROCÉDÉ DE FABRICATION CORRESPONDANT

(30) Priority: 14.02.2008 ES 200800387
(43) Date of publication of application: 03.11.2010
(73) Proprietor: Indo Internacional, S.A., 08174 Sant Cugat del Vallès, Barcelona (ES)
(72) Inventor: FERNÀNDEZ SERRANO, Ricardo, E-08203 Sabadell (Barcelona) (ES); GUTIÈRREZ BERASATEGUI, Eva, E-20600 Eibar (Guipùzcoa) (ES); VILAJOANA I MAS, Antoni, E-08302 Matarò (Barcelona) (ES); DÜRSTELER LÒPEZ, Juan Carlos, E-08860 Castelldefels (Barcelona) (ES)
(74) Representative: Curell Suñol S.L.P.
(86) International application number: PCT/EP2008/010647
(87) International publication number: WO 2009/100750

(56) References cited:
- EP-A- 1 205 774
- EP-A- 1 566 666
- EP-A- 1 688 764
- EP-A- 1 764 398
- EP-A- 1 816 489
- US-A1- 2007 178 315

## Description

### Field of the invention

The invention relates to polymeric based lenses that are highly abrasion resistant, which usually comprise a hardening layer and an interferential multi-layer, where the hardening layer is at least 500 nm (nanometres) thick and the interferential multi-layer is made up of a plurality of sub layers where each of said sub layers is less than 250 nm thick. The invention also relates to some manufacturing methods of these lenses.

### State of the art

Lens coating is well known, and in particular ophthalmic lenses of a polymeric or organic nature, with hardening layers to improve the abrasion resistance thereof. This coating method is carried out because the scratch resistance of this type of polymeric lenses is much less than that of mineral lenses. This hardening coating (lacquer) is usually applied by dipping in a (poly)siloxane, acrylic, methacrylic or polyurethane bath and subsequent hardening in an oven at temperatures between 100°C and 130°C. Via this method hardening layers of between 1 micron and 3 microns are obtained. Another possible technique for carrying out the hardening coating is by applying lacquers using the spinning technique with mechanical characteristics that are similar to the above but with a production process that only coats one lens surface in each stage.

It is also known to cover lenses with a stack of layers that have an anti-reflection (or interferential) function that enables them to reduce the amount of visible light reflected by the lens or with an interferential stack that has a mirror function to increase said reflected light. In order to obtain these results, usually a stack of between 4 and 6 layers is used, each of which is between 10 nm and 150 nm thick. This is usually done using PVD (Physical Vapour Deposition) techniques with an electron gun or thermal evaporation, although other techniques exist such as Plasma enhanced Chemical Vapour Deposition (PeCVD) or Sputtering.

The mechanical properties of these layers deposited by high vacuum afford the lacquered polymeric organic unit greater hardness and increased scratch and abrasion resistance. This abrasion resistance measurement is usually made in the industry using the so-called Bayer test by the firm Colts Laboratories, relating to the standard L-11-10-06 operational procedure, comparing the abrasion resistance to that of a CR39 substrate. Thus, a value of BR = 10 means that the treated lens is 10 times more resistant to abrasion than the CR39 lens. This test has been used in this invention.

Also a pressure-based test is usually used to measure the abrasion resistance of the lens, called the Steel Wool SW test by the firm Colts Laboratories, relating to the standard L-11-12-08 operational procedure. This test has also been used in this invention, but in a modified way: the time was increased to 10 minutes and the applied load was increased to 6 kg in view of the high abrasion resistance of the lenses.

Document EP 1.655.385, in the name of Satis Vacuum Industries Vertriebs - AG, describes a procedure wherein between the organic substrate and the interferential multi-layer a transition layer is sandwiched, made up of PeCVD and using hexamethyldisiloxane (HMDSO) as the precursor.

Document US 6.596.368, in the name of Essilor International, describes some specific sputtering methods that make it possible to improve the adherence of the interferential multi-layer to the polymeric substrate or to the hardening layer (the lacquer).

EP 1.566.666 A1 describes a plastic lens having a plastic lens base material, a primer layer formed on the plastic lens base material, and a hard coat layer formed on the primer layer, the hard coat layer being formed from a hard coat composition having (A) an inorganic fine particle having a particle diameter of 1 to 100 millimicrons, (B) an organic silicon compound ex-pressed in terms of a specified Formula(1), (C) a multi-functional epoxy compound, and (D) a curing catalyst. Such a plastic lens is excellent in shock impact resistance by including the primer layer and also shows improvements in scratch resistance, water resistance, and permanence properties while keeping the coloring properties of the hard coat layer of a colorable type.

EP 1.205.774 A2 describes a method for producing an optical element having a multi-layered antireflection film formed on a synthetic resin substrate, in which the antireflection film formed has good heat resistance, and its heat resistance lowers little with time. The method makes it possible to form high-refraction layers within a shorter period of time, not detracting from the good physical properties intrinsic to the layers. At least one high-refraction layer of the multi-layered anti-reflection film contains niobium oxide, zirconium oxide, yttrium oxide, and optionally aluminum oxide.

US2007/178315 describes an optical article comprising a transparent substrate which is made from organic or mineral glass and which has front and rear main faces, at least one of said faces being equipped with a multi-layer anti-reflective coating. The anti-reflective coating consists of at least two layers which absorb in the visible region and which comprise a substoichiometric titanium oxide, said visible-absorbing layers being such that the visible light transmission factor Tv is reduced by more than 10% in relation to the same article without the visible-absorbing layers.

Nevertheless, there is still the need to improve the abrasion resistance of polymeric-based lenses and also the need for the various layers of a polymeric based lens, particularly the interferential multi-layers, to adhere as much as possible.

In this description and claims the term "lens" must be understood as any optical system made up of at least one surface and having refraction and/or reflection properties. In other words, any optical system based on refraction phenomena (refraction systems) or reflection phenomena (reflection systems). Those optical systems that combine both effects must also be considered to be lenses, such as for example optical systems with a first refraction surface and a second reflection surface, optical surfaces with semitransparent surfaces, etc.

### Disclosure of the invention

The invention is defined by the appended claims.

The aim of the invention is to overcome these drawbacks. This aim is achieved by means of a lens of the type indicated at the beginning, characterised in that it comprises, in addition, a hard layer sandwiched between said hardening layer and said interferential multi-layer, wherein said hard layer is over 300 nm thick and is made from a material in the group made by: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic yttrium, Y₂O₃, magnesium, MgO, carbon, praseodymium, PrO₂, Pr₂O₃, tungsten, WO₃, silicon nitride, and silicon oxynitride.

In fact, by including this hard layer over 300 nm thick makes it possible to improve the unit's mechanical response. This is due to the fact that the unit's mechanical response to nanoindentation tests is that of the interferential multi-layer if the indentation penetration value is less than 10% of the thickness of the interferential multi-layer. If the value of the indentation penetration is greater, then the unit's mechanical response is influenced by the mechanical properties of the lower layers and, eventually, of the actual polymeric substrate. Therefore, the addition of this hard layer which, in fact, can be of the same material as any of the sub layers of the interferential multi-layer, but which is much thicker than any of the sub layers of the interferential multi-layer, makes it possible to noticeably improve the unit's mechanical properties, particularly its abrasion resistance. Therefore, this hard layer is not really playing an interferential role, but rather the role of improving the mechanical properties.

Nevertheless, including this hard layer hinders the adhesion of the interferential multi-layer, which can cause a problem in certain cases, particularly if a very thick hard layer is to be included. Therefore, advantageously the lens has a flexible layer, obtainable by polymerizing organometallic monomers using a PECVD and/or sputtering method, and arranged between said hardening layer and said hard layer. In fact, this flexible layer improves the adhesion of the interferential multi-layer because it makes the unit flexible and accommodates the state of residual stresses introduced with the hard layer and interferential multi-layer. The flexible layer thus obtained has intermediate mechanical properties between the hard layer (and the interferential multi-layer) and the hardening layer. This way, by combining the hard layer with the flexible layer it is possible to select the abrasion resistance value directly by selecting the thickness of the thick layer and flexible layer. The possibility of having processes whereby a wider range of abrasion resistances can be obtained, even tens of times the value of the lacquered lens, according to the lens manufacturing conditions means it is possible to design processes personalised to the needs of each specific application.

A person skilled in the art knows the technique of forming layers by polymerizing organometallic monomers and can recognise when a certain layer is formed using this technique. However, it is complicated to define this type of layers by their physical characteristics, and therefore it is necessary to define them by the way in which they are obtained. However, it must be clear that the flexible layer is advantageous in itself, irrespective of the method that has been used to produce it. Consequently, it must be clear that the term "obtainable" is intended to define what the layer itself is like, irrespective of the method used to obtain it.

Preferably the lens has an adherent layer less than 10 nm thick, sandwiched between said hardening layer and said flexible layer, where said adherent layer is made from material in the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic yttrium, Y₂O₃, magnesium, MgO, carbon, praseodymium, PrO₂, Pr₂O₃, tungsten, WO₃, silicon nitride, and silicon oxynitride. This way the unit's adherence is improved further.

Advantageously the flexible layer is thicker than the unit made up of the hard layer and the interferential multi-layer. Particularly, it is advantageous that the sum of the thickness of the hard layer plus the thickness of the interferential multi-layer is between 70% and 100% of the thickness of the flexible layer.

A preferable embodiment of a lens according to the invention is obtained by adding a second hard layer and a second flexible layer, sandwiched between the flexible layer and the hard layer, where the second hard layer is between 3 nm and 20 nm thick, and is made from a material in the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic yttrium, Y₂O₃, magnesium, MgO, carbon, praseodymium, PrO₂, Pr₂O₃, tungsten, WO₃, silicon nitride, and silicon oxynitride.

Advantageously, the interferential multi-layer comprises a plurality of layers or sub layers, preferably between 4 and 6 layers, where each layer is between 10 nm and 220 nm thick.

Preferably the hardening layer is the polysiloxane, acrylic, methacrylic or polyurethane base.

Advantageously the lens according to the invention has a final water-repellent layer, preferably perfluorided and between 5 nm and 40 nm thick.

Preferably the flexible layer and/or the second flexible layer have been made from an organometallic monomer from a family of organometallic monomers in the group of families made up of silicon family, zirconium family, titanium family and tantalum family. Particularly, preferably the flexible layer and/or the second flexible layer have been made from an organometallic monomer from the group made up of: hexamethyldisiloxane (HMDSO), tetraethyl orthosilicate (TEOS), titanium (IV) isopropoxide and tetrakis(dimethylamido)zirconium(IV).

Advantageously the interferential multi-layer and/or the first hard layer and/or the second hard layer has been made from a material from the group made up of: ZrO₂, SiO₂, Si₃N₄ and Ta₂O₅.

A further objective of the invention is a polymeric based lens with an abrasion resistance value greater than 20, measured in BR units according to the Bayer test. In fact, polymeric based lenses with an abrasion resistance value greater than 20 BR are not known, the method described in this invention being the only method capable of obtaining polymeric based lenses with such a high abrasion resistance. Similarly, also an objective of the invention is a polymeric based lens with an abrasion resistance value less than 0.35%, measured in Haze units according to the Steel Wool test, at 6 kg for 10 minutes and with a 0000 mesh. As in the previous case, polymeric based lenses with an abrasion resistance value less than 0.35% Haze are not known in said test conditions.

Furthermore, the aim of the invention is a method for manufacturing a polymeric based lens according to the invention, characterised in that it comprises a stage [a] of forming the hardening layer, a stage [b] of forming the hard layer, a stage [c] for forming the interferential multi-layer, and a stage [a'] of activating the surface of the hardening layer by high vacuum , where stage [a'] takes place before said stage [b]. In fact, performing a process to activate the surface of the hardening layer increases the superficial energy thereof promoting promotes the adherence of the layers deposited subsequently using high vacuum techniques. In view of the chemical nature of the hardening layer, the spectrum of possible chemical treatments that can increase its superficial energy without deteriorating its physical properties and cosmetic appearance is very limited. Nevertheless, the high vacuum processes, such as for example plasma, allow a large number of surface actions that do not deteriorate the physical and chemical properties of the lacquer, or its cosmetic appearance. Moreover, since the process is performed immediately before depositing the following layers using high vacuum techniques, it is not necessary to break the vacuum, which ensures that the surface will not be contaminated with products from the atmosphere once activated.

Preferably the activation stage is performed using a plasma activation process at a frequency greater than 50kHz. It is particularly advantageous that the plasmas be Ar/O₂/N₂ or mixtures thereof and that the pressure be between 10⁻² and 10⁻⁵ mbar.

Preferably radio frequency impulsed plasma is used and the power applied is between 50 W and 1000 W, producing voltages between 30 V and 500 V.

Advantageously the method comprises a stage [a"] of forming the adherence layer less than 10 nm thick, where stage [a"] takes places after stage [a'], where stage [a"] is carried out by sputtering with an inert gas, preferably argon, in presence of oxygen and with electric power greater than 1500 W, producing voltages over 400 V, preferably electric power greater than 2000 W, producing voltages over 650 V.

Preferably the method comprises stage [a"'] of forming the flexible layer, where stage [a"'] is performed before stage [b], where in stage [a"'] an organometallic monomer is polymerized, where in stage [a"'] a sputtering method and a PeCVD radio frequency method are performed simultaneously, where the sputtering uses inert atmospheric gas, preferably argon, in presence of oxygen and with electric power greater than 1000 W producing voltages over 300 V, preferably with electric power greater than 1500 W producing voltages over 400 V, and in the PeCVD method radio frequency plasma is used, an organometallic monomer is injected, the pressure is between 10⁻² and 10⁻⁵ mbar, and the applied power is between 500 W and 3000 W.

Advantageously stage [b] is a sputtering stage using inert atmospheric gas, preferably argon, in presence of oxygen or nitrogen and with electric power between 500 W and 3000 W producing voltages between 300 V and 800 V.

Preferably stage [c] is a sputtering stage using an inert atmospheric gas, preferably argon, in presence of oxygen or nitrogen alternatively with electric power between 500 W and 3000 W producing voltages between 300 V and 800 V.

Advantageously the method comprises a stage [d] of producing a final water-repellent layer, where stage [d] takes place after stage [c].

### Brief description of the drawings

Other advantages and characteristics of the invention will be appreciated from the following description, which is a non-limiting example of some preferable embodiments of the invention, with reference to the attached drawings, in which:
Figs. 1 to 5, are a diagrammatic view of a cross section of the layers arranged on the polymeric substrate of the lens, according to various embodiments of the invention.
Fig. 6, is a graph showing the abrasion resistance according to the Bayer test of a lens according to the invention, depending on the thickness of the unit made up of the hard layer and the interferential multi-layer, where the abrasion resistance is indicated in BR units.
Fig. 7, is a graph showing the abrasion resistance according to the Steel wool test of a lens according to the invention, depending on the thickness of the unit made up of the hard layer and the interferential multi-layer, where the abrasion resistance is indicated in Haze units (in %).

### Detailed description of some embodiments of the invention

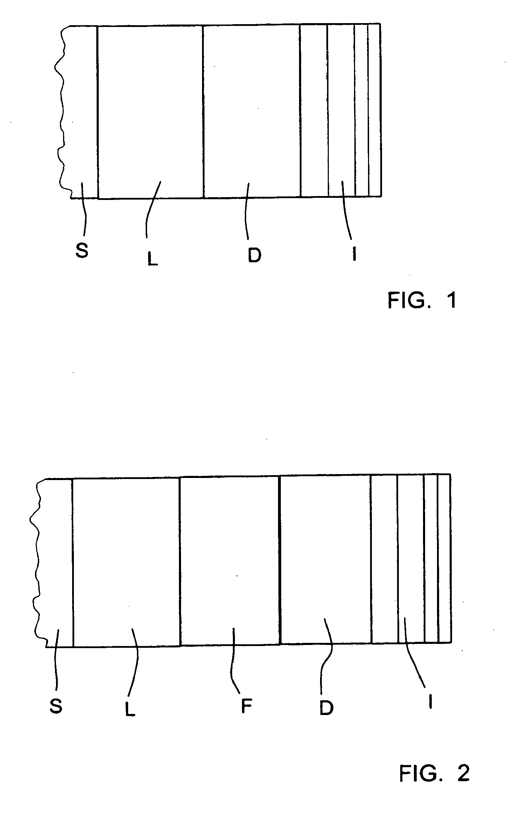

Fig. 1 shows a background embodiment of the invention. The starting point consists of a polymeric based lens that has a polymeric substrate S on which a hardening layer L has been deposited. A hard layer D has been deposited on hardening layer L, and an interferential layer I has been deposited on hard layer D.

Fig. 2 shows the embodiment of the invention wherein a flexible layer F has been added between hardening layer L and hard layer D.

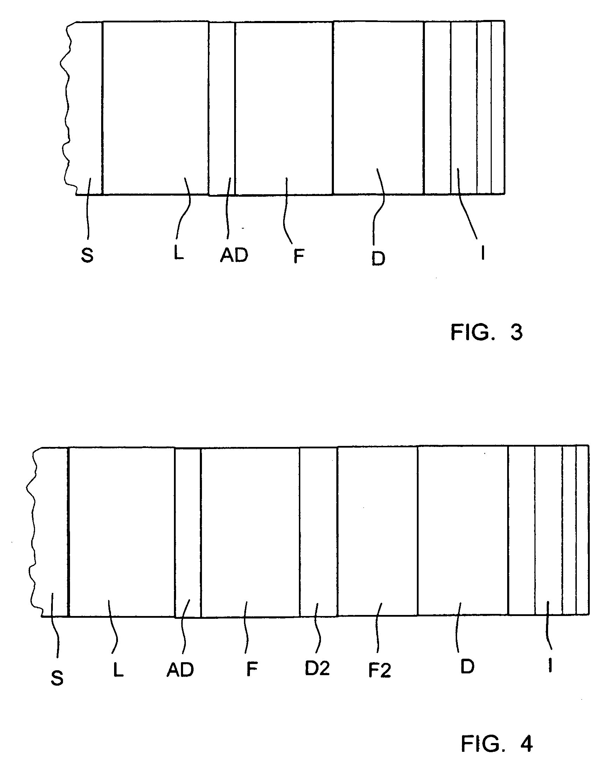

Fig. 3 shows that the structure of the layers also includes an adherence layer AD sandwiched between hardening layer L and flexible layer F

Fig. 4 shows the case wherein the structure of the layers also includes a second hard layer D2 and a second flexible layer F2 sandwiched between flexible layer F and hard layer D.

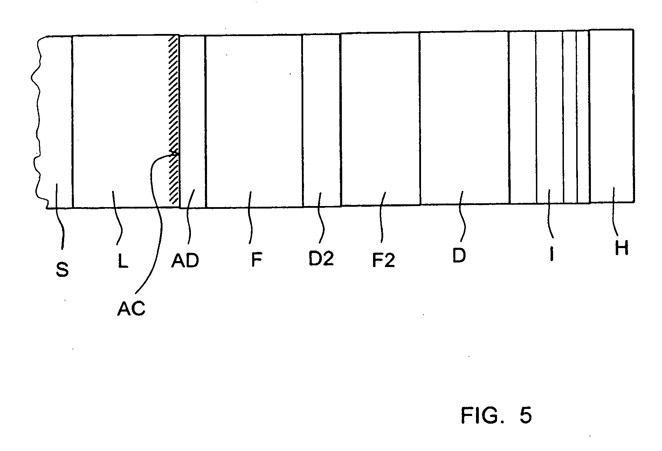

Finally, Fig. 5 shows the layer structure completed with a final water-repellent layer H. Also the activated surface AC of hardening layer L is indicated by stripes.

There is provided below, as an example, a description of a general method for obtaining the organic lens with high abrasion resistance.

The lens unit is covered by dipping or spinning the polysiloxane, acrylic, methacrylic or cured polyurethane lacquer, providing abrasion resistance of at least 4 in the Bayer test, it is washed conventionally to remove any possible superficial defects caused by the presence of dust and other contaminating agents and it is placed in an oven at 80°C for 2 hours preferably to remove the water adsorbed during the washing process.

Next the activation process of the surface of the lens + lacquer unit is performed, and a stack of layers made up of the following structure, is created inside the high vacuum equipment.

A SiO₂ layer less than 10 nm thick in conditions favouring the adherence of the rest of the structure deposited by high vacuum on the lacquered lens (in other words, with the hardening layer). This layer will be formed by sputtering a silicon or SiO₂ cathode with argon in the presence of oxygen with electric power as high as possible (>1500W), preferably at 2200W therefore producing electric voltages of at least 500 V, preferably 700 V.

A flexible layer is deposited over the above-mentioned adherence layer, in which the sputtering and PeCVD radio frequency impulsed plasma processes are combined to polymerize a monomer on the lens surface. To produce this flexible layer, an organometallic volatile silicon precursor, preferably HMDSO is introduced into a chamber during the sputtering process of the silicon or SiO₂ cathode with Ar/He/Ne in presence of oxygen. The entrance flows of the three components, argon, oxygen and HMDSO into the chamber will be between 0 sccm and 50 sccm, at a total pressure of between 10⁻² mbar and 10⁻⁵ mbar and applying electric power between 500W and 3000W with resultant voltages of between 300 V and 1000 V.

This flexible layer is divided into two parts by a hard, mineral layer of Si₃N₄ between 3nm and 20 nm. This is the one previously called the second hard layer. This way, the flexible layer is divided into two, thus forming what was previously called the flexible layer and the second flexible layer.

Then a sputtering layer is preferably deposited (it does not have to be SiO₂) that is more than 300 nm thick. This is the layer that was previously called the hard layer. The deposition conditions will be argon flows between 1 and 20 sccm, in the presence of oxygen or nitrogen between 3 sccm and 50 sccm with electric power of between 500W and 3000W producing voltages of between 300 V and 1000 V. The thickness of this layer of SiO₂ has to be such that in addition to the subsequent interferential stack, the total is similar to the thickness of the plasma polymerized flexible layer (in the first approximation between 70% and 100% of the thickness of the flexible layer).

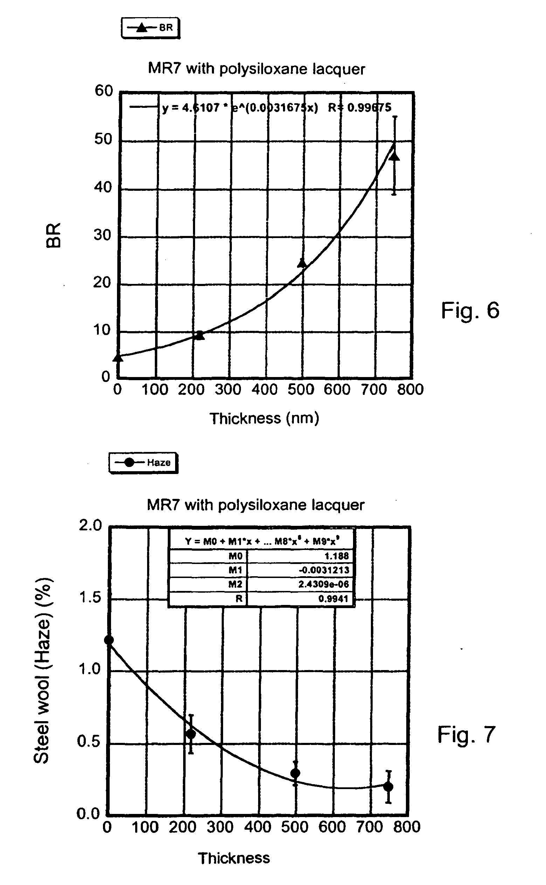

Increasing the thickness of these two layers deposited by PeCVD/sputtering and by sputtering increases the unit's scratch and abrasion resistance from the typical values of BR = 5 - 10 to BR=100 or greater as shown in Fig. 6 as an example.

Then the structure of interferential layers will be applied and deposited by sputtering a silicon cathode with argon, in the presence of oxygen to achieve the anti-reflection or mirror characteristic. The deposition conditions will be argon flows between 1 and 20 sccm, in the alternate presence of oxygen or nitrogen between 3 sccm and 50 sccm with electric power of between 500W and 3000W producing voltages of between 300 V and 1000 V.

In all the previous steps where a target or silicon cathode is mentioned that has to be oxydised or nitrided, this can be replaced with an oxide cathode such as for example a (SiO₂, Ta₂O₅, etc.) multi-target. In that case, the contribution of oxygen to obtain the suitable stoicheiometry is less and the process control greater.

Finally using high vacuum electron gun or dipping techniques a layer with a water-repellent function is deposited, preferably a perfluorided layer between 5 and 40 nm that reduces the friction coefficient, which makes it easier to clean the lens.

### Examples:

### a) Carrying out a process of BR = 47 including an interferential multi-layer on a MR7 lens lacquered with (poly)siloxane 2 microns thick.

The lens will preferably be covered by dipping in a (poly)siloxane lacquer cured at 110°C, giving abrasion resistances of BR=4/4.5. This lacquered and cured lens is washed in the presence of ultrasounds with a neutral soap to remove any possible surface defects due to the presence of dust and other contaminating agents, and it is introduced in an oven at 80°C for at least two hours and not more than 12 hours to remove the water adsorbed by the unit.

Then, using the high vacuum equipment, the activation process of the lacquered lens unit surface is performed and subsequently, without breaking the vacuum at any time until the end of the process, a layer of SiO₂ is deposited by sputtering a pure silicone cathode with 6 sccm of argon in the presence of oxygen (9 sccm) with electric power of 2200W producing a voltage of about 700 V.

A flexible layer is deposited on this adherence layer, which blends the sputtering and PeCVD radio frequency processes by introducing a volatile silicon precursor, preferably HMDSO into a chamber during the sputtering process (of the silicon cathode using argon in presence of oxygen). The dilutions of the three components, argon, oxygen and HMDSO will be:
- 40 sccm argon.
- 12 sccm oxygen.
- 8 sccm HMDSO.

The total pressure will ideally be 8'0x10⁻⁴ mbar and applying an electrical power of 1750W and a voltage of about 420 V.

The total thickness of this flexible layer has to be approximately 900 nm. It is possible to spread this layer with the aim of accommodating voltages in various parts of the process.

Subsequently a hard SiO₂ layer approximately 530 nm thick is deposited by sputtering a silicon cathode with argon. The deposition conditions will be an argon flow of 9 sccm, with an oxygen presence of about 12 sccm and with electric power of 1750W. The resulting voltage will be 550 V.

Then the structure of interferential layers (preferably 4) will be applied to build the interferential multi-layer deposited by sputtering a silicon cathode with argon, in the presence of oxygen/nitrogen alternatively to obtain the anti-reflection characteristic. The deposition conditions will be argon flows of 9 sccm, with an alternated oxygen or nitrogen presence of about 12 sccm and with electric power of 2000W in all cases. The voltages of the SiO₂ layers will be 550 V and those of the Si₃N₄ layers will be 450 V. The total thickness of the interferential multi-layer is 220 nm.

Owing to the thickness of the 900 nanometre layer polymerized by plasma in the above-mentioned deposition conditions, and the thickness of the 530 nm SiO₂ layer, a unit abrasion resistance value is obtained of about BR=47 on an MR7 substrate.

Finally a layer with a water-repellent function is deposited using the EBPVD, preferably a perfluorided layer of about 15 nm.

### TABLES:

(The flow values are indicated in sccm)
1.- Conditions of lacquer activation using plasma by high vacuum

| Function | Duration (seg.) | Power (W) | Voltage (V) | Flow [Ar] | Flow [O2] | Flow [N2] | Flow [HMDSO] | Pressure (mbar) |
|---|---|---|---|---|---|---|---|---|
| Activation | 50 | 300 | 200 | 20 | 20 | 0 | 0 | 6.0 10⁻⁴ |

2.- Deposition conditions of the adhesion layer by high vacuum

| Function | Thickness( nm) | Power (W) | Voltage (V) | Flow [Ar] | Flow [O2] | Flow [N2] | Flow [HMDSO] | Pressure (mbar) |
|---|---|---|---|---|---|---|---|---|
| Adhesion | 4 | 2200 | 700 | 6 | 9 | 0 | 0 | 2.010⁻⁴ |

3.- Deposition conditions of the flexible layer using PeCVD by high vacuum

| Function | Thickness (nm) | Power (W) | Voltage (V) | Flow [Ar] | Flow [O2] | Flow [N2] | Flow [HMDSO] | Pressure (mbar) |
|---|---|---|---|---|---|---|---|---|
| Flexible | 900 | 1750 | 420 | 40 | 12 | 0 | 8 | 8.0 10⁻⁴ |

4.- Deposition conditions of the hard SiO₂ layer more than 300nm thick

| Function | Thickness (nm) | Power (W) | Voltage (V) | Flow [Ar] | Flow [O2] | Flow [N2] | Flow [HMDSO] | Pressure (mbar) |
|---|---|---|---|---|---|---|---|---|
| SiO₂ | 530 | 1750 | 550 | 9 | 12 | 0 | 0 | 2.0 10⁴ |

5.- Deposition conditions of the interferential multi-layer by high vacuum

| Function | Thickness (nm) | Power (W) | Voltage (V) | Flow [Ar] | Flow [O2] | Flow [N2] | Flow [HMDSO] | Pressure (mbar) |
|---|---|---|---|---|---|---|---|---|
| SiO₂ | (2-220) | 1750 | 550 | 9 | 12 | 0 | 0 | 2.0 10⁻⁴ |
| Si₃N₄ | (2-150) | 2000 | 450 | 9 | 0 | 12 | 0 | 2.0 10⁻⁴ |

b) Figures 6 and 7 show the abrasion resistance results, according to the Bayer and Steel wool tests at 6 kg for 10 minutes with mesh 0000 respectively, obtained after subjecting an MR7 lens to the following processes:
- in both cases, the graph point corresponding to a thickness equivalent to 0, is the abrasion resistance of the lens with just the hardening layer (lacquer layer), and the point corresponding to a thickness equivalent to 220 nm is the abrasion resistance of a lens with a hardening layer and an interferential multi-layer that is 220 nm thick. In other words, both cases are the cases already known in the state of the art.
- the two following points now correspond to cases in which a hard layer of variable thickness has been sandwiched, the thickness of the interferential multi-layer remaining constant and equivalent to 220 nm. Specifically, the point of the graph corresponding to a thickness of 750 nm is the case of the lens in example a) above.

### c) Performance of a process wherein BR = 100 including an interferential multi-layer on a lacquered MR8 lens with a (poly)siloxane lacquer that is 2 microns thick.

Starting with a MR8 lens, and subjecting it to the same method as in example a) above, an abrasion resistance of BR = 100 according to the Bayer test is obtained.

## Claims

1. Polymeric based lens comprising a polymeric substrate (S) having a hardening layer (L) deposited thereon and an interferential layer (I), where said hardening layer (L) is at least 500 nm thick and said interferential multi-layer (I) is made up of a plurality of sub layers where the thickness of each of said sub layers is less than 250 nm, and comprising, in addition, a hard layer (D) sandwiched between said hardening layer (L) and said interferential multi-layer (I), where said hard layer (D) is over 300 nm thick and is made from a material from the group made up of: Cr₂O₃, ZrO, ZrO₂, SiO, SiO₂, TiO, TiO₂, Ti₃O₅, Al₂O₃, Ta₂O₅, CeO₂, HfO₂, indium and tin oxide, Y₂O₃, MgO, carbon, PrO₂, Pr₂O₃, WO₃, silicon nitride, and silicon oxynitride, **characterized in that** it has a flexible layer (F), obtainable by polymerizing organometallic monomers using a PECVD and/or sputtering method, arranged between said hardening layer (L) and said hard layer (D).

2. Lens according to claim 1, having an adherence layer (AD) less than 10 nm thick, sandwiched between said hardening layer (L) and said flexible layer (F), where said adherence layer (AD) is made from a material from the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic yttrium, Y₂O₃, magnesium, MgO, carbon, praseodymium, PrO₂, Pr₂O₃, tungsten, WO₃, silicon nitride, and silicon oxynitride.

3. Lens according to claim 1, wherein the sum of the thickness of said hard layer (D) plus the thickness of said interferential multi-layer is between 70% and 100% the thickness of said flexible layer (F).

4. Lens according to any of the claims 1 to 3, having a second hard layer (D2) and a second flexible layer (F2), sandwiched between said flexible layer (F) and said hard layer (D), where said second hard layer (D2) is between 3 nm and 20 nm thick and is made from a material from the group made up of: metallic chrome, Cr₂O₃, metallic zirconium, ZrO, ZrO₂, metallic silicon, SiO, SiO₂, metallic titanium, TiO, TiO₂, Ti₃O₅, metallic aluminium, Al₂O₃, metallic tantalum, Ta₂O₅, metallic cerium, CeO₂, metallic hafnium, HfO₂, indium and tin oxide, metallic yttrium, Y₂O₃, magnesium, MgO, carbon, praseodymium, PrO₂, Pr₂O₃, tungsten, WO₃, silicon nitride, and silicon oxynitride.

5. Lens according to any of the claims 1 to 4, wherein the interferential multi-layer (I) comprises a plurality of layers, preferably between 4 and 6 layers, where each layer is between 10 nm and 220 nm thick.

6. Lens according to any of the claims 1 to 5, wherein said flexible layer (F) and/or said second flexible layer (F2) are producible from an organometallic monomer from a family of organometallic monomers included in the group of families made up of: the silicon family, zirconium family, titanium family and tantalum family.

7. Lens according to any of the claims 1 to 6, wherein interferential multi-layer (I) and/or said first hard layer (D) and/or said second hard layer (D2) is producible from a material from the group made up of: ZrO₂, SiO₂, Si₃N₄ y Ta₂O₅.

8. Lens according to any of the claims 1 to 7, having an abrasion resistance value greater than 20, measured in BR units according to the Bayer test.

9. Lens according to any of the claims 1 to 8, having an abrasion resistance value less than 0.35%, measured in Haze units according to the Steel Wool test at 6 kg for 10 minutes and with mesh 0000.

10. Manufacturing method of a polymeric based lens according to any of the claims 1 to 7, which comprises a stage [a] of forming said hardening layer (L), a stage [b] of forming said hard layer (D), a stage [c] of forming said interferential multi-layer (I), and a stage [a'] of activating the surface of the hardening layer (L) by high vacuum, where said stage [a'] takes place before said stage [b].

11. Method according to claim 10, wherein said activation stage is carried out via a plasma activation process, at a frequency greater than 50kHz.

12. Method according to one of the claims 10 or 11, which comprises a stage [a"] of forming said adherence layer (AD) less than 10 nm thick, where said stage [a"] takes place after said stage [a'], where said stage [a"] is carried out by sputtering with an inert gas, preferably argon, in presence of oxygen and with electric power greater than 1500 W producing voltages greater than 400 V, preferably with electric powers greater than 2000 W producing voltages greater than 650 V.

13. Method according to any of the claims 10 to 12, which comprises a stage [a"'] of forming said flexible layer (F), where said stage [a"'] is before said stage [b], where in said stage [a"'] an organometallic monomer is polymerized, where in said stage [a"'] a sputtering method and a radio frequency PeCVD method is performed simultaneously, where said sputtering uses an inert gas atmosphere, preferably argon, in presence of oxygen and with electric power greater than 1000 W producing voltages greater than 300 V, preferably with electric power greater than 1500 W producing voltages greater than 400 V, and in said PeCVD radio frequency plasma is used, an organometallic monomer is injected, the pressure is between 10⁻² and 10⁻⁵ mbar, and the power applied is between 500 W and 3000 W.

14. Method according to any of the claims 10 a 13, wherein said stage [b] is a stage of sputtering with an inert gas atmosphere, preferably argon, in presence of oxygen or nitrogen and with electric power between 500 W and 3000 W producing voltages between 300 V and 800 V.

15. Method according to any of the claims 10 to 14, wherein said stage [c] is a stage of sputtering with an inert gas atmosphere, preferably argon, alternatively in presence of oxygen or nitrogen and with electric power of between 500 W and 3000 W producing voltages between 300 V and 800 V.

## Patentansprüche

1. Auf Polymer basierende Linse umfassend ein polymeres Substrat (S) mit einer darauf abgeschiedenen Härtungsschicht (L) und einer Interferenzschicht (I), wobei die Härtungsschicht (L) eine Dicke von mindestens 500 nm aufweist und die Mehrlagen-Interferenzschicht (I) aus einer Mehrzahl von Unterschichten gebildet ist, wobei die Dicke jeder der Unterschichten weniger als 250 nm beträgt, und außerdem umfassend eine Hartschicht (D), die sandwichartig zwischen der Härtungsschicht (L) und der Mehrlagen-Interferenzschicht (I) angeordnet ist, wobei die Hartschicht (D) eine Dicke von mehr als 300 nm aufweist und aus einem Material aus der Gruppe bestehend aus: Cr₂O₃, ZrO, ZrO₂, SiO, SiO₂, TiO, TiO₂, Ti₃O₅, Al₂O₃, Ta₂O₅, CeO₂, HfO₂, Indium- und Zinnoxid, Y₂O₃, MgO, Kohlenstoff, PrO₂, Pr₂O₃, WO₃ Siliciumnitrid und Siliciumoxynitrid gebildet ist,
**dadurch gekennzeichnet, dass**
sie eine flexible Schicht (F) aufweist, die durch Polymerisieren metallorganischer Monomere unter Verwendung eines PECVD- und/oder Sputterverfahrens erhältlich ist, die zwischen der Härtungsschicht (L) und der Hartschicht (D) angeordnet ist.

2. Linse nach Anspruch 1, mit einer Adhäsionsschicht (AD) von weniger als 10 nm Dicke, die sandwichartig zwischen der Härtungsschicht (L) und der flexiblen Schicht (F) angeordnet ist, wobei die Adhäsionsschicht (AD) aus einem Material aus der Gruppe bestehend aus: metallischem Chrom, Cr₂O₃, metallischem Zirconium, ZrO, ZrO₂, metallischem Silicium, SiO, SiO₂, metallischem Titan, TiO, TiO₂, Ti₃O₅, metallischem Aluminium, Al₂O₃, metallischem Tantal, Ta₂O₅, metallischem Cer, CeO₂, metallischem Hafnium, HfO₂, Indium- und Zinnoxid, metallischem Yttrium, Y₂O₃, Magnesium, MgO, Kohlenstoff, Praseodym, PrO₂, Pr₂O₃, Wolfram, WO₃, Siliciumnitrid und Siliciumoxynitrid gebildet ist.

3. Linse nach Anspruch 1, bei der die Summe der Dicke der Hartschicht (D) plus der Dicke der Mehrlagen-Interferenzschicht zwischen 70 % und 100 % der Dicke der flexiblen Schicht (F) beträgt.

4. Linse nach einem der Ansprüche 1 bis 3, mit einer zweiten Hartschicht (D2) und einer zweiten flexiblen Schicht (F2), die sandwichartig zwischen der flexiblen Schicht (F) und der Hartschicht (D) angeordnet ist, wobei die zweite Hartschicht (D2) eine Dicke zwischen 3 nm und 20 nm aufweist und aus einem Material aus der Gruppe bestehend aus: metallischem Chrom, Cr₂O₃, metallischem Zirconium, ZrO, ZrO₂, metallischem Silicium, SiO, SiO₂, metallischem Titan, TiO, TiO₂, Ti₃O₅, metallischem Aluminium, Al₂O₃, metallischem Tantal, Ta₂O₅, metallischem Cer, CeO₂, metallischem Hafnium, HfO₂, Indium- und Zinnoxid, metallischem Yttrium, Y₂O₃, Magnesium, MgO, Kohlenstoff, Praseodym, PrO₂, Pr₂O₃, Wolfram, WO₃, Siliciumnitrid und Siliciumoxynitrid gebildet ist.

5. Linse nach einem der Ansprüche 1 bis 4, bei der die Mehrlagen-Interferenzschicht (I) eine Mehrzahl von Schichten aufweist, bevorzugt zwischen 4 und 6 Schichten, wobei jede Schicht eine Dicke zwischen 10 nm und 220 nm aufweist.

6. Linse nach einem der Ansprüche 1 bis 5, bei der die flexible Schicht (F) und/oder die zweite flexible Schicht (F2) aus einem metallorganischen Monomer aus einer Familie von metallorganischen Monomeren herstellbar ist, die der Gruppe von Familien bestehend aus: der Siliciumfamilie, der Zirconiumfamilie, der Titanfamilie und der Tantalfamilie angehören.

7. Linse nach einem der Ansprüche 1 bis 6, bei der die Mehrlagen-Interferenzschicht (I) und/oder die erste Hartschicht (D) und/oder die zweite Hartschicht (D2) aus einem Material aus der Gruppe bestehend aus: ZrO₂, SiO₂, Si₃N₄ und Ta₂O₅ herstellbar ist.

8. Linse nach einem der Ansprüche 1 bis 7, mit einem Abriebfestigkeitswert von mehr als 20, gemessen in BR-Einheiten nach dem Abriebtestverfahren Bayer Test.

9. Linse nach einem der Ansprüche 1 bis 8, mit einem Abriebfestigkeitswert von weniger als 0,35 %, gemessen in Haze-Einheiten nach dem Testverfahren mit Stahlwolle während 10 Minuten unter 6 kg und mit einer Feinheit von 0000.

10. Herstellungsverfahren für eine auf Polymer basierende Linse nach einem der Ansprüche 1 bis 7, das umfasst:
einen Schritt [a] zum Ausbilden der Härtungsschicht (L),
einen Schritt [b] zum Ausbilden der Hartschicht (D),
einen Schritt [c] zum Ausbilden der Mehrlagen-Interferenzschicht (I) und
einen Schritt [a'] zum Aktivieren der Oberfläche der Härtungsschicht (L) durch Hochvakuum, wobei der Schritt [a'] vor dem Schritt [b] stattfindet.

11. Verfahren nach Anspruch 10, wobei der Aktivierungsschritt in einem Plasma-Aktivierungsprozess bei einer Frequenz von mehr als 50 kHz ausgeführt wird.

12. Verfahren nach einem der Ansprüche 10 oder 11, das umfasst:
einen Schritt [a"] zum Ausbilden der Adhäsionsschicht (AD) von weniger als 10 nm Dicke, wobei der Schritt [a"] nach dem Schritt [a'] stattfindet, wobei der Schritt [a"] durch Sputtern mit einem Inertgas, bevorzugt Argon, in Gegenwart von Sauerstoff und mit einer elektrischen Leistung von mehr als 1500 W, die Spannungen über 400 V erzeugt, bevorzugt mit elektrischen Leistungen von mehr als 2000 W, die Spannungen über 650 V erzeugen, ausgeführt wird.

13. Verfahren nach einem der Ansprüche 10 bis 12, das umfasst:
einen Schritt [a"'] zum Ausbilden der flexiblen Schicht (F), wobei der Schritt [a"'] vor dem Schritt [b] erfolgt, wobei in dem Schritt [a"'] ein metallorganisches Monomer polymerisiert wird, wobei in dem Schritt [a"'] ein Sputterverfahren und ein Hochfrequenz-PECVD-Verfahren gleichzeitig durchgeführt werden, wobei beim Sputtern eine Inertgasatmosphäre, bevorzugt Argon, in Gegenwart von Sauerstoff und mit einer elektrischen Leistung von mehr als 1000 W, die Spannungen über 300 V erzeugt, bevorzugt mit einer elektrischen Leistung von mehr als 1500 W, die Spannungen über 400 V erzeugt, verwendet wird und beim PECVD ein Hochfrequenzplasma verwendet wird, ein metallorganisches Monomer eingebracht wird, wobei der Druck zwischen 10⁻² und 10⁻⁵ mbar beträgt und die angelegte Leistung zwischen 500 W und 3000 W beträgt.

14. Verfahren nach einem der Ansprüche 10 bis 13, bei dem der Schritt [b] als Schritt zum Sputtern in einer Inertgasatmosphäre, bevorzugt Argon, in Gegenwart von Sauerstoff oder Stickstoff und mit einer elektrischen Leistung zwischen 500 W und 3000 W, wobei Spannungen zwischen 300 V und 800 V erzeugt werden, vorgesehen ist.

15. Verfahren nach einem der Ansprüche 10 bis 14, bei dem der Schritt [c] als Schritt zum Sputtern in einer Inertgasatmosphäre, bevorzugt Argon, alternativ in Gegenwart von Sauerstoff oder Stickstoff und mit einer elektrischen Leistung zwischen 500 W und 3000 W, wobei Spannungen zwischen 300 V und 800 V erzeugt werden, vorgesehen ist.

## Revendications

1. Lentille à base de polymère, comprenant un substrat polymérique (S) ayant une couche de durcissement (L) déposée sur celui-ci et une couche d'interférence (I), dans laquelle ladite couche de durcissement (L) a une épaisseur d'au moins 500 nm et ladite multicouche d'interférence (I) est constituée d'une pluralité de sous-couches, où l'épaisseur de chacune desdites sous-couches est inférieure à 250 nm, et comprenant, en plus, une couche dure (D) enserrée entre ladite couche de durcissement (L) et ladite multicouches d'interférence (I), où ladite couche dure (D) a une épaisseur supérieure à 300 nm et est constituée d'une matière choisie dans le groupe constitué par : Cr₂O₃, ZrO, ZrO₂, SiO, SiO₂, TiO, TiO₂, Ti₃O₅, Al₂O₃, Ta₂O₅, CeO₂, HfO₂, indium et oxyde d'étain, Y₂O₃, MgO, carbone, PrO₂, Pr₂O₃, WO₃, nitrure de silicium, et oxynitrure de silicium, **caractérisée en ce qu'**elle a une couche flexible (F), pouvant être obtenue par polymérisation de monomères organométalliques en utilisant un procédé PECVD et/ou un procédé de pulvérisation, disposée entre ladite couche de durcissement (L) et ladite couche dure (D).

2. Lentille selon la revendication 1, ayant une couche d'adhérence (AD) ayant une épaisseur inférieure à 10 nm, enserrée entre ladite couche de durcissement (L) et ladite couche flexible (F), où ladite couche d'adhérence (AD) est constituée d'une matière choisie dans le groupe constitué par : chrome métallique, Cr₂O₃, zirconium métallique, ZrO, ZrO₂, silicium métallique, SiO, SiO₂, titane métallique, TiO, TiO₂, Ti₃O₅, aluminium métallique, Al₂O₃, tantale métallique, Ta₂O₅, cérium métallique, CeO₂, hafnium métallique, HfO₂, indium et oxyde d'étain, yttrium métallique, Y₂O₃, magnésium, MgO, carbone, praséodyme, PrO₂, Pr₂O₃, tungstène, WO₃, nitrure de silicium et oxynitrure de silicium.

3. Lentille selon la revendication 1, dans laquelle la somme de l'épaisseur de ladite couche dure (D) plus l'épaisseur de ladite multicouche d'interférence est située entre 70 % et 100 % de l'épaisseur de ladite couche flexible (F).

4. Lentille selon l'une quelconque des revendications 1 à 3, ayant une seconde couche dure (D2) et une seconde couche flexible (F2), prise en sandwich entre ladite couche flexible (F) et ladite couche dure (D), où ladite seconde couche dure (D2) a une épaisseur située entre 3 nm et 20 nm et est constituée d'une matière choisie dans le groupe constitué par : chrome métallique, Cr₂O₃, zirconium métallique, ZrO, ZrO₂, silicium métallique, SiO, SiO₂, titane métallique, TiO, TiO₂, Ti₃O₅, aluminium métallique, Al₂O₃, tantale métallique, Ta₂O₅, cérium métallique, CeO₂, hafnium métallique, HfO₂, indium et oxyde d'étain, yttrium métallique, Y₂O₃, magnésium, MgO, carbone, praséodyme, PrO₂, Pr₂O₃, tungstène, WO₃, nitrure de silicium et oxynitrure de silicium.

5. Lentille selon l'une quelconque des revendications 1 à 4, dans laquelle la multicouche d'interférence (I) comprend une pluralité de couches, de préférence entre 4 et 6 couches, chaque couche ayant une épaisseur située entre 10 nm et 220 nm.

6. Lentille selon l'une quelconque des revendications 1 à 5, dans laquelle ladite couche flexible (F) et/ou ladite seconde couche flexible (F2) peuvent être produites à partir d'un monomère organométallique provenant d'une famille de monomères organométalliques incluse dans le groupe des familles constitué par : la famille du silicium, la famille du zirconium, la famille du titane et la famille du tantale.

7. Lentille selon l'une quelconque des revendications 1 à 6, dans laquelle ladite multicouche d'interférence (I) et/ou ladite première couche dure (D) et/ou ladite seconde couche dure (D2) peut être produite à partir d'une matière choisie dans le groupe constitué par : ZrO₂, SiO₂, Si₃N₄ et Ta₂O₅.

8. Lentille selon l'une quelconque des revendications 1 à 7, ayant une valeur de résistance à l'abrasion supérieure à 20, mesurée en unités BR selon le test de Bayer.

9. Lentille selon l'une quelconque des revendications 1 à 8, ayant une valeur de résistance à l'abrasion inférieure à 0,35 %, mesurée en unités Haze selon le test à la paille de fer à 6 kg pendant 10 minutes et avec un maillage 0000.

10. Procédé de fabrication d'une lentille à base de polymère selon l'une quelconque des revendications 1 à 7, qui comprend une étape [a] de formation de ladite couche de durcissement (L), une étape [b] de formation de ladite couche dure (D), une étape [c] de formation de ladite multicouche d'interférence (I), et une étape [a'] d'activation de la surface de la couche de durcissement (L) par vide poussé, où ladite étape [a'] a lieu avant ladite étape [b].

11. Procédé selon la revendication 10, dans lequel ladite étape d'activation est réalisée via un procédé d'activation au plasma, à une fréquence supérieure à 50 kHz.

12. Procédé selon l'une quelconque des revendications 10 ou 11, qui comprend une étape [a"] de formation de ladite couche d'adhérence (AD) d'une épaisseur inférieure à 10 nm, où ladite étape [a"] prend place après ladite étape [a'], où ladite étape [a"] est réalisée par pulvérisation d'un gaz inerte, de préférence l'argon, en présence d'oxygène et avec une puissance électrique supérieure à 1500 W produisant des tensions supérieures à 400 V, de préférence avec des puissances électriques supérieures à 2000 W produisant des tensions supérieures à 650 V.

13. Procédé selon l'une quelconque des revendications 10 à 12, qui comprend une étape [a"'] de formation de ladite couche flexible (F), ladite étape [a"'] étant située avant ladite étape [b], où, dans ladite étape [a"'], un monomère organométallique est polymérisé, où, dans ladite étape [a"'], un procédé de pulvérisation et un procédé PeCVD par radiofréquence sont réalisés simultanément, ladite pulvérisation utilisant une atmosphère de gaz inerte, de préférence l'argon, en présence d'oxygène et avec une puissance électrique supérieure à 1000 W produisant des tensions supérieures à 300 V, de préférence avec une puissance électrique supérieure à 1500 W produisant des tensions supérieures à 400 V, et, dans ledit PeCVD, un plasma généré par radiofréquence est utilisé, un monomère organométallique est injecté, la pression est située entre 10⁻² et 10⁻⁵ mbar, et la puissance appliquée est située entre 500 W et 3000 W.

14. Procédé selon l'une quelconque des revendications 10 à 13, dans lequel ladite étape [b] est une étape de pulvérisation avec une atmosphère de gaz inerte, de préférence l'argon, en présence d'oxygène ou d'azote, et avec une puissance électrique située entre 500 W et 3000 W produisant des tensions situées entre 300 V et 800 V.

15. Procédé selon l'une quelconque des revendications 10 à 14, dans lequel ladite étape [c] est une étape de pulvérisation avec une atmosphère de gaz inerte, de préférence l'argon, alternativement en présence d'oxygène ou d'azote, et avec une puissance électrique située entre 500 W et 3000 W produisant des tensions situées entre 300 V et 800 V.
